Europäisches Patentamt

European Patent Office

Office européen des brevets

(11) Publication number: **0 178 855**
**B1**

(12) **EUROPEAN PATENT SPECIFICATION**

(45) Date of publication of patent specification: **05.09.90**

(21) Application number: **85307279.1**

(22) Date of filing: **11.10.85**

(51) Int. Cl.⁵: **H 01 R 43/00, H 05 K 7/14, H 05 K 13/00**

(54) Electrical connecting arrangements.

(30) Priority: **13.10.84 GB 8425910**

(43) Date of publication of application:
**23.04.86 Bulletin 86/17**

(45) Publication of the grant of the patent:
**05.09.90 Bulletin 90/36**

(84) Designated Contracting States:
**AT BE CH DE FR GB IT LI LU NL SE**

(56) References cited:
**EP-A-0 023 324**
**EP-A-0 152 508**
**FR-A-2 462 083**
**FR-A-2 485 806**
**US-A-2 991 188**

**IBM TECHNICAL DISCLOSURE BULLETIN, vol. 25, no. 7 A, December 1982, pages 3510,3511, New York, US; W.J. SUMMA: "Insulator bonding system for connector"**

(73) Proprietor: **PLESSEY OVERSEAS LIMITED**
**Vicarage Lane**
**Ilford Essex IG1 4AQ (GB)**

(72) Inventor: **Sheppard, Barry John**
**8 Conifer Avenue Parkstone**
**Poole Dorset (GB)**
Inventor: **Carretta, Mark Vincent**
**112 Medway**
**Ilford Essex (GB)**

(74) Representative: **Nicholson, Ronald**
**Intellectual Property Department The Plessey Company plc 2-60 Vicarage Lane**
**Ilford Essex IG1 4AQ (GB)**

Courier Press, Leamington Spa, England.

## Description

This invention relates to electrical connecting arrangements and relates more specifically to methods of fabricating and processing component parts for use in such arrangements.

Electrical connecting arrangements may comprise so-called back-plane assemblies including printed circuit board edge connectors. In order to protect such back-plane assemblies against deleterious environmental conditions the back-plane assemblies may be provided, where necessary, with conformal protective coatings which may be applied by means of dipping operations. However, difficulties arise during such dipping operations due to the protective coating material penetrating by capillary action into certain contact regions of electrical connectors forming part of such assemblies.

According to the present invention the above-mentioned difficulties are overcome by at least partially filling those interstices of electrical connector(s) or other component(s) of the arrangement where penetration due to capillary action of the coating material is to be excluded during the dipping step with suitable masking material prior to applying the conformal coating and thereafter dissolving the masking material out of the said interstices.

In carrying out the invention the masking material may be injected into the interstices by the use of a liquid injection system which may be arranged to inject the requisite volume of liquid masking material. It may be arranged that the position of the injection nozzle of the injection system as well as the volume of the masking liquid to be injected and the pressure of such injection may be controlled automatically so that the interstices of the component concerned are filled sequentially with the requisite amount of masking material.

The masking material is preferably injected after the electrical connector or other electrical component to be masked has been secured to the back-plane assembly or other connecting arrangement but the masking material could obviously be injected before such attachment of the component to the assembly.

The specific masking material employed may be chosen according to various requirements but it has been found that water-soluble TC—564—1 produced by Techform Laboratories Incorporated, Los Angeles, U.S.A. is eminently suitable.

The conformal coating material may also be selected from a range of suitable materials but the material marketed under the name of "Humiseal" 1B31 has been found to produce very satisfactory conformal coatings.

By way of example the present invention will now be described with reference to the accompanying drawings in which:

Figure 1 shows in section a printed circuit board edge connector attached to a back-plane assembly and ready to be injected with masking material; and,

Figure 2 is a fragmentary perspective view of the edge connector of Figure 1.

Referring to the drawings the printed circuit board edge connector 1 has a moulded plastics body 2 which accommodates a multiplicity of suitably formed contacts 3 within moulded recesses and openings 4 and 5 of the body 2. The connector contacts 3 are arranged in rows along connector body 2 so that they will make electrical contact with conductors located at the edges of a printed circuit board upon insertion of the board into the longitudinal channel 4 of the connector. Extended connector pins of these contacts 3 pass through holes in a back-plane assembly board 7. Soldered wire connections (not shown) will be made to the connector pins of the connector and the underside of the back-plane assembly board will usually accommodate a complex network of wiring with soldered and unsoldered connections and terminal pins for connecting various electrical components which will be mounted above and below the back-plane board 7 but which in the interests of clarity have been excluded from the drawings.

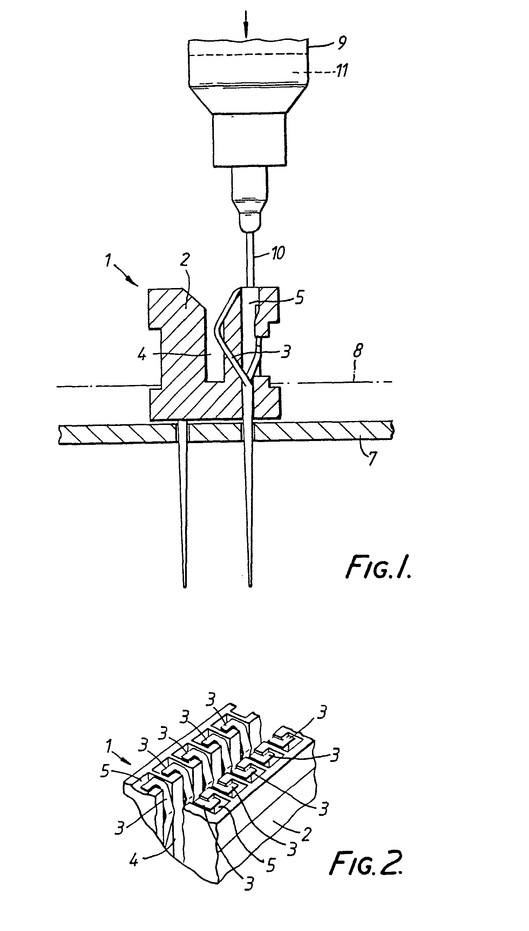

In order to provide a protective conformal coating over the wiring/connections and terminals and certain components embodied in the back-plane assembly the assembly may be dipped into a suitable coating material, such as Humiseal 1B31 which may be thinned down to the requisite consistency. The back-plane assembly may be dipped to the level 8 indicated in Figure 1 and after dipping the coating material may be allowed to cure for about 24 hours.

However, in order to prevent the coating material from rising up into the recesses or interstices 5 of the electrical connector during the dipping process the present invention proposes filling the interstices 5 of the connector body with masking material, such as water-soluble TC—564—1 suitably diluted, prior to dipping of the back-plane assembly into the coating material.

It will also be appreciated that other parts of the back-plane assembly may be masked, as required, by the application of masking material to the parts concerned or by the application to such parts of suitably formed masks (e.g. heat shrunk plastics sleeving and removable stopper plugs). In this way ready access to these parts to permit inter alia subsequent electrical connections to be made thereto is provided for.

However, as regards the filling of the edge connector interstices 5 with the masking material the material may, after suitable cleaning and drying of the connector in order to remove dirt, grease etc., by injected into each of the interstices in turn by using an injector syringe 9 coupled to an automatic liquid dispenser (not shown). The dispenser may be controlled automatically to dispense through the injector nozzle 10 of the syringe 9 by the application for a pre-set time period of suitable air pressure, the requisite amount of masking material 11. The syringe nozzle may be located over each of the interstices 5 of the electrical connector 1 in turn as masking material 11 is dispensed from the nozzle 10 into the interstices 5. Such sequential filling of the interstices 5 may readily be automated in order to avoid, where possible, the need for operator control of the dispensing/injection operation.

When the injected masking material in the edge connector 1 has set and masking of any further parts of the back-plane assembly has been accomplished the back-plane assembly will then be dipped into a bath of coating material (e.g. Humiseal 1B31) of the desired consistency and to assist the covering action and penetration of the coating material into all those crevices of the back-plane assembly which need to be coated the back-plane assembly may be subjected to oscillatory movement during the dipping procedure. Since the interstices 5 of the electrical connector 1 contain masking material the protective coating material cannot rise up through the connector body 2 so that it encroaches on the actual contacts 3 of the connector.

It may here be mentioned that a fluorescent dye may be incorporated into the coating material to facilitate inspection of the coating under ultra-violet irradiation after application.

When the protective coating has been cured after about 24 hours the masking material may be dissolved with hot or cold tap water and the edge connector then dried. Masks applied to other parts of the back-plane assembly may also be removed as appropriate and after the necessary operations (e.g. soldering) have been performed suitable coating material may subsequently be brushed on to any surfaces which need to be environmentally protected.

As will be appreciated, the back-plane assemblies or other assemblies needing to be environmentally protected may take many different forms and the various procedures and sequences of operations employed in their fabrication will vary widely. However, the principle of the present invention will still be applicable, that is, to prevent the penetration of coating material into contact regions of the edge connector or other component, as the case may be, during the dipping process and then to dissolve out the masking material after the protective conformal coating has been applied and cured.

## Claims

1. A process for protecting an electrical connecting arrangement (e.g. back-plane assembly) against deleterious environmental conditions by providing the arrangement with a conformal protective coating applied to parts of the arrangement by dipping, characterised in that prior to applying the conformal coating selected interstices (4, 5) of electrical connector(s) or other component(s) of the arrangement are at least partially filled with suitable masking material (11) to prevent penetration of the conformal coating material into said interstices during the dipping step due to capillary action and characterised in that following the dipping step the masking material is dissolved out of the interstices.

2. A process as claimed in claim 1, characterised in that the masking material is injected into the interstices by the use of a liquid injection system (9, 10) arranged to inject the requisite volume of liquid masking material.

3. A process as claimed in claim 2, characterised in that the position of the injection nozzle (10), the volume of the masking liquid (11) to be injected and the pressure of such injection are controlled automatically so that the interstices of the component concerned are filled sequentially with the requisite amount of masking material.

4. A process as claimed in claim 1, 2 or 3, characterised in that the masking material (11) is introduced into the interstices (4, 5) of the electrical connector(s) or other component(s) after attachment thereof to the electrical connecting arrangement.

5. A process as claimed in claim 1, characterised in that the masking material (11) is water soluble.

## Patentansprüche

1. Verfahren zum Schützen von einer elektrischen Anschlussanordnung (z.B. Rück- oder Gegenplattenanordnung) (back-plane assembly) gegen schädigende Umgebungsbedingungen durch Versehen der Anordnung mit einer konformen schützenden Beschichtung, die an Teile der Anordnung durch Tauchen aufgetragen wird, dadurch gekennzeichnet, dass vor dem Auftragen der konformen Beschichtung ausgewählte Zwischen- oder Hohlräume (4, 5) von einem oder mehreren elektrischen Anschlüssen oder anderen Komponenten der Anordnung mindestens teilweise mit einem geeigneten Maskiermaterial (11) gefüllt werden, um Penetration des konformen Beschichtungsmaterials in die besagten Zwischen- oder Hohlräume während dem Tauchvorgang in Folge von Kapillarwirkung zu verhindern, und dass nachfolgend dem Tauchvorgang das Maskiermaterial aus den Zwischen- oder Hohlräumen herausgelöst wird.

2. Verfahren nach Anspruch 1, dadurch gekennzeichnet, dass das Maskiermaterial in die Zwischen- oder Hohlräume unter Verwendung von einem Flüssiginjektionssystem (9, 10) injiziert wird, das angeordnet ist, um das erforderliche Volumen des flüssigen Masiermaterials zu injizieren.

3. Verfahren nach Anspruch 2, dadurch gekennzeichnet, dass die Position der Injektionsdüse (10), das Volumen der Maskierflüssigkeit (11), die injiziert wird, und der Druck dieser Injektion automatisch geregelt werden, so dass die Hohl- oder Zwischenräume der betreffenden Komponenten der Reihe nach mit der erforderlichen Menge von Maskiermaterial gefüllt werden.

4. Verfahren nach einem der Ansprüche 1 bis 3, dadurch gekennzeichnet, dass das Maskiermaterial (11) in die Hohl- oder Zwischenräume (4, 5) des oder der elektrischen Anschlüsse oder anderen Komponenten eingefüllt wird, nachdem diese an die elektrische Anschlussanordnung befestigt worden sind.

5. Verfahren nach Anspruch 1, dadurch gekennzeichnet, dass das Maskiermaterial (11) wasserlöslich ist.

**Revendications**

1. Procédé de protection d'une matrice de connexion électrique (par exemple un ensemble de fond de panier) contre les conditions du milieu environnant, par disposition d'un revêtement protecteur complémentaire sur la matrice, ce revêtement étant appliqué sur des parties de la matrice par trempage, caractérisé en ce que, avant application du revêtement complémentaire, les interstices choisis (4, 5) du connecteur ou des connecteurs électriques ou d'autres composants de la matrice sont remplis au moins partiellement d'une matière convenable de masquage (11) afin que la pénétration de la matière du revêtement complémentaire dans les interstices sous l'action des forces capillaires soit empêchée pendant l'étape de trempage, et caractérisé en ce que, après l'étape de trempage, la matière de masquage est retirée des interstices par dissolution.

2. Procédé selon la revendication 1, caractérisé en ce que la matière de masquage est injectée dans les interstices à l'aide d'un système d'injection de liquide (9, 10) destiné à injecter le volume nécessaire de la matière liquide de masquage.

3. Procédé selon la revendication 2, caractérisé en ce que la position de l'aiguille d'injection (10), le volume du liquide de masquage (11) qui doit être injecté, et la pression d'injection sont réglés automatiquement afin que les interstices de l'élément constituant concerné soient remplis successivement de la quantité nécessaire de la matière de masquage.

4. Procédé selon la revendication 1, 2 ou 3, caractérisé en ce que la matière de masquage (11) est introduite dans les interstices (4, 5) du connecteur ou des connecteurs électriques ou des autres composants après fixation de ceux-ci à la matrice de connexion électrique.

5. Procédé selon la revendication 1, caractérisé en ce que la matière de masquage (11) est hydrosoluble.

FIG. 1.

FIG. 2.